# EUROPEAN PATENT APPLICATION

(11) **EP 3 128 573 A1**
(43) Date of publication of application: **08.02.2017**
(21) Application number: 14888163.4
(22) Date of filing: 27.11.2014
(51) Int. Cl.: H01M 2/10, H01M 10/04

(54) **DEFORMATION-DETECTING SENSOR FOR SEALED SECONDARY BATTERY**

(30) Priority: 31.03.2014 JP 2014072401; 27.06.2014 JP 2014133115
(71) Applicant: Toyo Tire & Rubber Co., Ltd., Osaka-shi, Osaka 550-8661 (JP)
(72) Inventor: FUKUDA, Takeshi, Osaka-shi, Osaka 550-8661 (JP); SHIGETO, Junichi, Osaka-shi, Osaka 550-8661 (JP)
(74) Representative: Eisenführ Speiser
(86) International application number: PCT/JP2014/081459
(87) International publication number: WO 2015/151332

(57) **Abstract**

A deformation detecting sensor for a sealed secondary battery of the present invention includes a resin layer which changes its property in association with deformation of a portion to be measured, the resin layer having an elastic modulus within the range of 0.01-10 MPa. It can be possible to detect bulging of the sealed secondary battery without lowering the degree of freedom in designing the structure of the sealed secondary battery.

## Description

### Technical Field

The present invention relates to a deformation detection sensor for sealed secondary battery, and more particularly, a deformation detection sensor for sealed secondary battery, a deformation detecting sensor system for sealed secondary battery, a unit cell comprising a deformation detecting sensor for sealed secondary battery, a battery module comprising a deformation detecting sensor for sealed secondary battery, a battery pack comprising a deformation detecting sensor for sealed secondary battery, a method for detecting bulging of a unit cell, a method for detecting bulging of a battery module, and a method for detecting bulging of a battery pack.

### Background Art

A sealed secondary battery has been widely used as power sources for portable devices such as mobile phones and notebook computers, in which a non-aqueous electrolyte secondary battery such as a lithium ion secondary battery or an aqueous electrolyte secondary battery such as a nickel-hydrogen secondary battery is sealed together with a protective circuit in a battery case such as a metal can or a laminate film. The protective circuit has a function for monitoring the voltage of the battery and blocking the charging current or discharging current when the overcharging or overdischarging occurs.

Since the non-aqueous electrolyte secondary battery uses a flammable organic electrolyte solution, the inside pressure of the battery may be raised by decomposition gas of the electrolyte solution and electrodes or vapor gas of the electrolyte solution generated by heat caused by overcharging or short circuit, and may cause bulging of the battery, and may result in the explosion of the battery in the worst case. Moreover, in the case of aqueous electrolyte secondary battery, the battery may be expanded by the structural change of the electrode active material through charge and discharge and also by generated decomposition gas of the electrolyte solution and electrodes.

In contrast, a method for preventing rupture of the sealed secondary battery comprising detecting in advance the bulging of the sealed second battery and blocking the charging current or discharging current has been studied. As a method of detecting the bulging of the sealed secondary battery, for example, a method using a temperature sensor (Patent Document 1) and a method of using a strain gauge (Patent Document 2) have been proposed. Patent Document 1 discloses a method in which, in a battery module having a plurality of unit cells, a space for inserting a sensor for attaching a temperature sensor for detecting temperature of the unit cell is formed at an arbitrary position in the battery module. Further, Patent Document 2 discloses a sealed secondary battery comprising a casing containing a positive electrode and a negative electrode and being capable of charging and discharging, and a safety element adhered to the surface of the casing and whose resistance value changes according to the bulging of the casing. It is described in Patent Document 2 that strain gauges are used as the safety element and those strain gauges are adhered to the surface of the casing using double-sided adhesive tape or double-sided adhesive film.

### Citation List

### Patent Literature

[Patent Document 1] Japanese Patent Publication No. 2013-171697
[Patent Document 2] Japanese Patent Publication No. 2006-128062

### Summary of Invention

### Technical Problem

However, in the methods of Patent Document 1 and Patent Document 2, since it is necessary to secure a place for attaching a temperature sensor or a strain gauge, there is a problem that the degree of freedom in designing the structure of the sealed secondary battery is low. Particularly, in the method of Patent Document 2, since the strain gauge cannot be attach only to a planar portion, it is difficult to attach the strain gauze to a non-planar portion such as a corner or curved portion, and thus structures of sealed secondary battery to which it applies is further limited. Thus, there is a need for a sealed secondary battery which is capable to detect bulging of the battery without lowering the degree of freedom in designing the structure of the sealed secondary battery.

Accordingly, an object of the present invention is to provide a deformation detecting sensor for sealed secondary battery which is capable of detecting bulging of the non-aqueous electrolyte secondary battery without lowering the degree of freedom in designing the structure of the sealed secondary battery, a deformation detecting sensor system for sealed secondary battery, a unit cell comprising a deformation detecting sensor for sealed secondary battery, a battery module comprising a deformation detecting sensor for sealed secondary battery, a battery pack comprising a deformation detecting sensor for sealed secondary battery, a method for detecting bulging of a unit cell, a method for detecting bulging of a battery module, and a method for detecting bulging of a battery pack.

### Solution to Problem

To solve the above problems, the present invention provides a deformation detecting sensor for sealed secondary battery used with a unit cell, a battery module and a battery pack of the sealed secondary battery, which is characterized by comprising at least a resin layer whose property changes in association with deformation of a portion to be measured, the resin layer having an elastic modulus within the range of 0.01-10 MPa.

Further, a deformation detecting sensor system for sealed secondary battery of the present invention is characterized by comprising the above deformation detecting sensor and a detection part for detecting a change of a magnetic field of a magnetic resin layer.

Further, a unit cell of the present invention is characterized by comprising a battery body housed in the package case, the battery body comprising a positive electrode, a negative electrode and a separator, wherein the unit cell comprises the above deformation detecting sensor for sealed secondary battery attached on the outside surface thereof.

Further, a battery module of the present invention is characterized by comprising a plurality of unit cells for sealed secondary battery electrically connected one another, each unit cell comprising a battery body housed in a package case, the battery body comprising a positive electrode, a negative electrode and a separator, wherein the battery module comprises the above deformation detecting sensor attached on the outside surface of at least one unit cell or on the inside or outside surface of the package case of the battery module.

Further, a battery pack of the present invention is characterized by comprising a plurality of battery modules which are electrically connected one another.

Further, the battery module of the present invention, for example, can be produced by the following method. That is, a method for producing a battery module of the present invention is characterized by comprising: housing a plurality of unit cells in a package case; injecting a precursor for a resin layer into at least a portion of gap between the plurality of unit cells and the package case; and curing the precursor to form the resin layer, wherein the property of the resin layer changes in association with deformation of a portion to be measured, and wherein the resin layer has an elastic modulus within the range of 0.01-10 MPa.

Further, a method for detecting a bulging of a unit cell of the present invention is characterized by comprising detecting a change of a magnetic field caused by a magnetic layer by using the above unit cell.

Further, a method for detecting a bulging of a battery module of the present invention is characterized by comprising detecting a change of a magnetic field caused by a magnetic layer by using the above battery module.

Further, a method for detecting a bulging of a battery pack of the present invention is characterized by comprising detecting a change of a magnetic field caused by a magnetic layer by using the above battery pack.

### Advantageous Effects of Invention

According to the present invention, since the resin layer can be easily deformed and can be stuck to non-planar portion as well as planar portion, the place for sticking the deformation detecting sensor is not limited. Thus, without lowering the degree of freedom in designing the structure of the sealed secondary battery, it is possible to provide a deformation detecting sensor for sealed secondary battery which is capable to detect the bulging of the battery.

### Brief Description of Drawings

Figure 1 is a schematic diagram showing an example of a structure of the battery module of the present invention, (a) is a perspective view, and (b) is a transverse cross-sectional view.
Figure 2 is a schematic diagram showing another example of a structure of the battery module of the present invention, (a) is a perspective view, and (b) is a transverse cross-sectional view.
Figure 3 is a schematic diagram showing another example of a structure of the battery module of the present invention, (a) is a perspective view, and (b) is a longitudinal cross-sectional view.

### Description of Embodiment

Hereinafter, embodiments of the present invention will be described in detail.

The deformation detecting sensor for sealed secondary battery used with a unit cell, a battery module and a battery pack of the sealed secondary battery, which is characterized by comprising at least a resin layer whose property changes in association with deformation of a portion to be measured, the resin layer having an elastic modulus within the range of 0.01-10 MPa.

The deformation detecting sensor for sealed secondary battery includes at least a resin layer which changes its property in association with deformation of a portion to be measured and have an elastic modulus within the range of 0.01-10 MPa. The resin layer used in the present invention, which is made of a functional resin which changes its physical property in association with deformation of a portion to be measured, is a sensor layer detecting a deformation of the portion to be measured. The resin layer may be a single layer structure or multilayer structure. As for the multilayer structure, the whole structure of the multilayer structure may change its physical property in association with deformation of a portion to be measured, and the composition of each single layer constituting the multilayer structure may be the same or different from each other. Further, as for the deformation detecting sensor, at least one another layer may be provided on one or both of the pair of main surfaces of the resin layer as needed. Examples of another layer may include an adhesive layer or sticky layer for improving the adhesion to the portion to be measured. The size of the deformation detecting sensor may be selected according to the size of the portion to be measured, for example, the surface area of the upper surface is 20-10000 mm², preferably 30-1000 mm². The thickness of the deformation detecting sensor is 100-3000 µm, preferably 500-1500 µm.

The functional polymer may be prepared by adding functional filler having a desired function to a resin component to be a matrix. Examples of the functional filler include magnetic filler imparting magnetic property and filler imparting electrical property such as an electrically conductive filler imparting electrical conductivity. A resin having magnetic property (hereinafter, referred to as magnetic resin) can be prepared by adding a magnetic filler to the resin component to be a matrix. Further, a resin having an electrical property (hereinafter, referred to as conductive resin) can be prepared by adding an electrically conductive filler to a resin component to be a matrix. Hereinafter, the case of using a magnetic filler and conductive filler as a functional filler will be explained.

Examples of the magnetic fillers include rare earth based, iron-based, cobalt-based, nickel-based, oxide-based and the like. The rare earth based magnetic filler, by which high magnetic force is obtained, is preferable. The shape of the magnetic filler is not particularly limited, and may be spherical, flat shape, needle shape, columnar shape or undetermined shape. The magnetic filler has an average particle diameter of 0.02-500 µm, preferably 0.1-400 µm, more preferably 0.5-300 µm. When the average particle diameter of the magnetic filler is smaller than 0.02 µm, the magnetic property of the magnetic filler is poor. When the average particle diameter of the magnetic filler is larger than 500 µm, the mechanical property of the magnetic filler is poor and the magnetic filler becomes brittle. Further, the thickness of the magnetic resin layer is not particularly limited, 100-3000 µm, preferably 300-2000 µm, more preferably 500-1500 µm. When the thickness is smaller than 100 µm, the magnetic resin becomes brittle and handleability is reduced when adding a predetermined amount of the magnetic filler. When the thickness is larger than 3000 µm, the degree of freedom in designing the structure of the sealed secondary battery is lowered.

The magnetic filler may be introduced into the resin component after magnetization. It is preferable to magnetize the magnetic filler after the magnetic filler is introduced into the resin component. This is because, by magnetizing the magnetic filler after the magnetic filler is introduced into the resin component, the magnetic pole direction is easily aligned, and thus it becomes easy to detect the magnetic force. Further, in order to improve an affinity between the magnetic filler and the resin component, the magnetic filler may be subjected to a coupling treatment.

Examples of the electrically conductive filler include carbon-based fillers such as carbon black, carbon fiber, graphite and metal-based fillers: metal fine powder such as Ag, Cu, Ni; metal oxide such as ZnO, SnO₂; and metal fiber such as Al, stainless. The metal fine powder is preferable because a large change in electric resistance can be obtained by its slight deformation. When using the electrically conductive filler, the degree of contact between the electrically conductive fillers changes in association with the deformation of the portion to be measured, and the bulging of the portion to be measured can be detected by measuring a change of electrical resistance and electrostatic capacitance associated with the above change of the degree of contact between the electrically conductive fillers. The shape of the electrically conductive filler is not particularly limited, and may be spherical, flat shape, needle shape, columnar shape or undetermined shape. The average particle diameter of the electrically conductive filler is 0.02-500 µm, preferably 0.1-400 µm, more preferably 0.5-300 µm. When the average particle diameter is smaller than 0.02 µm, the electrical property of the electrically conductive filler is lowered. When the average particle diameter is larger than 500 µm, the mechanical property of the electrically conductive filler is lowered and the electrically conductive filler becomes brittle. Further, the thickness of the electrically conductive resin layer is not particularly limited, and may be 100-3000 µm, preferably 300-2000 µm, more preferably 500-1500 µm.

The functional filler containing resin (hereinafter, also referred to as filler-containing resin) has an elastic modulus of 0.01-10 MPa, preferably 0.02-7 MPa, more preferably 0.03-5 MPa, more preferably 0.05-3 MPa. When the elastic modulus is smaller than 0.01 MPa, handleability becomes difficult due to high tackiness, and it becomes difficult to attach to the portion to be measured of the sealed secondary battery. When the elastic modulus is larger than 10 MPa, the resin is hardly deformed and it becomes difficult to attach to a non-planar portion. In order to adjust the elastic modulus of the filler-containing resin to be in the range of 0.01-10 MPa, for example, methods such as adding a plasticizer, adding a monool component, or adjusting NCO index can be used. The elastic modulus used in the present invention is the compression modulus measured according to JIS K-7312. Further, when the multilayer structure is employed as the resin layer of the present invention, it is preferable that the elastic modulus of each layer constituting the multilayer structure is 0.01-10 MPa.

As a resin component, a thermoplastic resin, a thermosetting resin, or mixtures thereof may be used. Examples of the thermoplastic resins include such as styrene-based thermoplastic elastomer, polyolefin thermoplastic elastomer, polyurethane-based thermoplastic elastomers, polyester thermoplastic elastomers, polyamide thermoplastic elastomers, polybutadiene-based thermoplastic elastomers, polyisoprene-based thermoplastic elastomer, fluorine-based thermoplastic elastomer, ethylene-ethyl acrylate copolymers, ethylene-vinyl acetate copolymer, polyvinyl chloride, polyvinylidene chloride, chlorinated polyethylene, fluorine resins, polyamide, polyethylene, polypropylene, polyethylene terephthalate, polybutylene terephthalate, polystyrene, polybutadiene and the like. Examples of the thermosetting resins include diene synthetic rubbers such as polyisoprene rubber, polybutadiene rubber, styrene-butadiene rubber, polychloroprene rubber, acrylonitrile-butadiene rubber; non-diene-based rubber such as ethylene-propylene rubber, ethylene-propylene-diene rubber, butyl rubber, acrylic rubber, polyurethane rubber, fluorine rubber, silicone rubber, epichlorohydrin rubber; natural rubber, polyurethane resins, silicone resins, and epoxy resins. A thermosetting resin is preferable because the thermosetting resin can suppress the sag of the resin due to heat generation or overload of the battery. More preferably, the resin component is a polyurethane resin (polyurethane elastomer, urethane rubber) and silicone resin (silicone elastomer, silicone rubber). In order to adjust the elastic modulus to a desired value, a plasticizer may be added to the resin shown above, and the resin may be a foam body.

Polyurethane elastomers are obtained by reacting a polyol with a polyisocyanate. When using the polyurethane elastomer as the elastomer component, the active hydrogen-containing compound, a solvent and the magnetic filler are mixed and then the isocyanate component is mixed to obtain a mixed solution. Further, the solvent and the filler are mixed with the isocyanate component and then the active hydrogen-containing compound is mixed to obtain also a mixed solution. The magnetic elastomer can be produced by casting the mixed solution within a mold subjected to releasing treatment and subsequently heating the mixed solution to its curing temperature to cure the mixed solution. When using a silicone elastomer as the elastomer component, the magnetic elastomer can be produced by mixing solvent and magnetic filler with a precursor of a silicone elastomer to obtain a mixture, and placing the mixture in the mold and subsequently heating and curing the mixture. When necessary, the solvent may not be added.

As an isocyanate component which can be used in the polyurethane elastomer, compounds known in the field of polyurethane can be used. Examples of isocyanate components include aromatic diisocyanates such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, m-xylylene diisocyanates; aliphatic diisocyanates such as ethylene diisocyanate, 2,2,4-trimethylhexamethylene diisocyanate, 1,6-hexamethylene diisocyanate; alicyclic diisocyanates such as 1,4-cyclohexane diisocyanate, 4,4'-dicyclohexyl methane diisocyanate, isophorone diisocyanate, and norbornane diisocyanate. These isocyanate components may be used alone or in combination of two or more thereof. Further, the isocyanate component may be a urethane-modified, allophanate-modified, biuret-modified or isocyanurate-modified isocyanate. Preferable isocyanate component is 2,4-toluene diisocyanate, 2,6-toluene diisocyanate, 4,4'-diphenylmethane diisocyanate, and more preferable isocyanate component is 2,4-toluene diisocyanate, 2,6-toluene diisocyanate.

As the active hydrogen-containing compound, active hydrogen-containing compound conventionally used in the field of polyurethane can be used. Examples of the active hydrogen-containing compounds include high molecular weight polyols: polyether polyols represented by polytetramethylene glycol, polypropylene glycol, polyethylene glycol, copolymers of propylene oxide, ethylene oxide and the like; polyester polyols represented by polybutylene adipate, polyethylene adipate, polyol consisting of 3-methyl-1,5-pentanediol and adipic acid and the like; polyester polycarbonate polyols represented by a reaction mixture of polyester glycols such as polyester polycarbonate polyol or polycaprolactone with an alkylene carbonate; polyester polycarbonate polyols obtained by reacting ethylene carbonate with a polyhydric alcohol to form a reaction mixture, and then reacting the reaction mixture with an organic dicarboxylic acid; and polycarbonate polyols obtained by a transesterification reaction of a polyhydroxyl compound and aryl carbonate. These may be used alone or in combination of two or more thereof.

In addition to the high molecular weight polyol components described above as the active hydrogen-containing compound, a low molecular weight polyol component and low molecular weight polyamine component may be used. Examples of the low molecular weight polyol components include ethylene glycol, 1,2-propylene glycol, 1,3-propylene glycol, 1,4-butanediol, 1,6-hexanediol, neopentyl glycol, 1,4-cyclohexanedimethanol, 3-methyl-1,5-pentanediol, diethylene glycol, triethylene glycol, 1,4-bis (2-hydroxyethoxy) benzene, trimethylolpropane, glycerin, 1,2,6 hexane triol, pentaerythritol, tetra methylol cyclohexane, methyl glucoside, sorbitol, mannitol, dulcitol, sucrose, 2,2,6,6-tetrakis (hydroxymethyl) cyclohexanol, and triethanolamine. Examples of the low molecular weight polyamine component include ethylenediamine, tolylenediamine, diphenylmethane diamine, diethylenetriamine. These may be used alone or in combination of two or more thereof. Further, it may be possible to mix polyamines. Examples of the polyamines include 4,4'-methylenebis (o-chloroaniline) (MOCA), 2,6-dichloro-p-phenylenediamine, 4,4'-methylenebis (2,3-dichloroaniline), 3,5-bis(methylthio)-2,4-toluene diamine, 3,5-bis(methylthio)-2,6-toluene diamine, 3,5-diethyl toluene -2,4-diamine, 3,5-diethyl toluene-2,6-diamine, trimethylene glycol-di-p-aminobenzoate, polytetramethylene oxide-di-p-aminobenzoate, 1,2-bis(2-aminophenylthio) ethane, 4,4'-diamino-3,3'-diethyl-5,5'-dimethyl-diphenylmethane, N,N'-di-sec-butyl-4,4'-diaminodiphenylmethane, 4,4'-diamino-3,3'-diethyl diphenylmethane, 4,4'-diamino-3,3'-diethyl-5,5'-dimethyl-diphenylmethane, 4,4'-diamino-3,3'-diisopropyl-5,5'-dimethyl-diphenylmethane, 4,4'-diamino-3,3',5,5'-tetraethyl-diphenylmethane, 4,4'-diamino-3,3',5,5'-tetraisopropyl diphenyl methane, m-xylylene diamine, N,N'-di-sec-butyl-p-phenylene diamine, m-phenylene diamine, and p-xylylene diamine. Preferred active hydrogen-containing compounds include polytetramethylene glycol, polypropylene glycol, copolymers of propylene oxide and ethylene oxide, a polyester polyol consisting of 3-methyl-1,5-pentanediol and adipic acid, more preferably polypropylene glycol, copolymers of propylene oxide and ethylene oxide.

As for the preferred combinations of the isocyanate components and active hydrogen-containing compounds, examples include combinations of one or more of the isocyanate components selected from the group consisting of 2,4-toluene diisocyanate, 2,6-toluene diisocyanate, and 4,4'-diphenylmethane diisocyanate, and one or more of the active hydrogen-containing compounds selected from the group consisting of polytetramethylene glycol, polypropylene glycol, copolymers of propylene oxide and ethylene oxide, and a polyester polyol consisting of 3-methyl-1,5-one-pentanediol and adipic acid. More preferable combinations include 2,4-toluene diisocyanate and/or 2,6-toluene diisocyanate as the isocyanate component, and polypropylene glycol and/or copolymers of propylene oxide and ethylene oxide as the active hydrogen-containing compound.

When using the polyurethane elastomer, the residual hydroxyl group concentration is within the range of 0.2-0.9 meq/g, preferably 0.2-0.85 meq/g. When the residual hydroxyl group concentration is less than 0.2 meq/g, adhesive strength to the unit cell or the battery module degrades, while when the residual hydroxyl group concentration is more than 0.9 meq/g, the curing of the filler containing resin becomes insufficient.

The amount of the functional filler in the filler containing resin, for example, the amount of the magnetic filler is 1-450 parts by weight, preferably 2-400 parts by weight relative to 100 parts by weight of the resin component. When the amount is less than 1 part by weight, it becomes difficult to detect a change of a magnetic field, when it exceeds 450 parts by weight, the magnetic resin itself becomes brittle.

In the present invention, the magnetic filler may be unevenly distributed in the resin component at a specific uneven distribution degree. The "uneven distribution degree" as used herein is a number value representing a degree that the magnetic filler is unevenly distributed in the resin component, and it is measured by the following methods. A sample is cut from the prepared magnetic resin with a razor blade, a cross-section of the sample is observed using a digital microscope at a magnification of 100. Using an image analysis software("WinROOF" from Mitani Corporation), the obtained image is divided into three equal parts in the thickness direction, that is, an upper layer, a middle layer and a lower layer, and the number of particles of magnetic filler in each layer is counted. An abundance ratio of the magnetic filler in each layer is determined by calculating a ratio of the number of particles of each layer to that of the middle layer. In addition, the uneven distribution degree is determined by calculating a value of [(the abundance ratio of the magnetic filler in the upper layer)-(the abundance ratio of the magnetic filler in the lower layer)]. The higher the value of uneven distribution degree, the magnetic filler is more unevenly distributed. In the present invention, it is preferable that the magnetic filler is unevenly distributed in the thickness direction of the magnetic resin layer and that the magnetic filler concentration on the side of the unit cell is higher than that on the side of the magnetic sensor. When the magnetic filler is unevenly distributed on the side of the unit cell, a slight bulging of the unit cell can be detected with higher sensitivity.

The uneven distribution degree of the magnetic filler is in the range of 1-90, preferably 2-90, more preferably 3-80. The detection sensitivity of the magnetic resin against the bulging of the battery can be further increased by making the uneven distribution degree to be more than or equal to 1. For example, when using polyurethane elastomers as the resin component, if the uneven distribution degree is less than 1, and thus the amount of the magnetic filler on the side of the unit cell is small, a slight bulging of the unit cell sometimes cannot be detected. Further, when the uneven distribution degree is more than 90, the irregularities are generated on the surface of the magnetic resin layer, and there is a problem that the adhesive property between the unit cell and the magnetic resin layer is deteriorated.

In order to unevenly distributing the magnetic filler, a method can be used, in which, after introducing the magnetic filler in the resin component, the magnetic filler is subjected to stand at room temperature or a predetermined temperature and to be set naturally by its own weight. The uneven distribution degree can be adjusted by changing the time and/or temperature for standing. Further, the magnetic filler may be unevenly distributed by using a physical force such as a centrifugal force or magnetic force.

Further, when the resin layer of the present invention is a multilayer structure, a plurality of single layers having different concentrations of magnetic filler may be laminated so that the magnetic filler is unevenly distributed on the unit cell side or electrode body side. For example, when disposing a resin layer composed of two layers structure on the outside surface of the unit cell, one single layer containing magnetic filler may be disposed on the unit cell side and another single layer containing no magnetic filler may be laminated on the above one single layer. In that case, the magnetic filler may be or may not be unevenly distributed in the one single layer containing magnetic filler. Further, when disposing a resin layer composed of three or more layers, three single layers may be laminated to form a concentration gradient in which the magnetic filler is unevenly distributed on the unit cell side or electrode body side. In that case, a single layer containing no magnetic filler is laminated as an outermost layer which is farthest from the unit cell side or electrode body side.

The amount of the electrically conductive filler in the filler containing resin is in the range of 1-450 parts by weight, preferably 2-400 parts by weight with respect to 100 parts by weight of the resin component. When the amount of the electrically conductive filler is less than 1 part by weight, it is difficult to detect the change of electric resistance. When the amount of the electrically conductive filler is more than 450 parts by weight, the electrically conductive resin itself is brittle.

The deformation detecting sensor system for sealed secondary battery comprises a deformation sensor of the present invention and a detection part for detecting a change of property of the filler containing resin layer. A magnetic sensor may be used in the detection part in the case of the magnetic resin. The magnetic sensor may be generally a sensor used to detect the change of magnetic field. Examples of the magnetic sensors include a magneto-resistive element (e.g., semiconductor compound magnetoresistive element, an anisotropic magnetoresistance element (AMR), giant magnetoresistance element (GMR) or tunnel magnetoresistive element (TMR)), Hall element, an inductor, MI elements, fluxgate sensor and the like. From the viewpoint of having a wide sensitivity region, the Hall element is preferred. The magnetic sensor may be arranged near the filler containing resin layer, preferably so as to face the filler containing resin layer. Further, in the case of the electrically conductive resin, one or more pairs of electrodes are formed on the same plane or opposite planes, and the electrodes are used by being electrically connected to the detection part. As the detection part, a voltage detector, a resistance detector or a capacitance detector can be used. These voltage detectors and capacitance detector may be incorporated into a protection circuit of the battery as needed.

The sealed secondary battery using a deformation detection sensor of the present invention is obtained by hermetically housing a battery body comprising a positive electrode, a negative electrode and a separator, for example, the battery body being produced by laminating or winding a positive electrode and a negative electrode via a separator, in a package case. Examples thereof include a non-aqueous electrolyte secondary battery such as a lithium ion secondary battery, alkaline secondary battery such as a nickel-cadmium secondary battery and a nickel-hydrogen secondary battery. Further, the deformation detecting sensor of the present invention may be used in a unit cell, battery module or battery pack of the sealed secondary batteries. Here, the unit cell is a cell comprising a positive electrode, a negative electrode and a separator and being sealed in a package case. Further, the battery module is obtained by electrically connecting a plurality of the unit cells. Further, the battery pack is obtained by electrically connecting a plurality of the battery modules.

The portion to be measured to which the deformation detection sensor of the present invention is stuck is an easily deformable portion of the sealed secondary battery. Examples of the portion to be measured include an outside surface of a package case of the unit cell, inside and outside surfaces of a package case of the battery module, and inside and outside surfaces of a package case of battery pack. The area of the portion to be measured is not particularly limited and may be appropriately selected depending on the size and sticking position of the package case.

When detecting bulging of a unit cell, a change of property of a resin layer constituting the deformation detection sensor of the present invention can be measured by using a detection part and by employing the unit cell having the deformation detection sensor of the present invention on the outside surface of its package case. Further, when detecting bulging of a battery module, a change of property of a resin layer constituting the deformation detection sensor of the present invention can be measured by using the detection part and by employing the unit cell having the deformation detection sensor of the present invention on the inside or outside surface of its package case or by using a package case having the deformation detection sensor of the present invention on the inside or outside surface of its package case as a package case for the battery module. Further, when detecting bulging of a battery pack, a change of property of a resin layer constituting a deformation detection sensor of the present invention can be measured by using the detection part and by employing the unit cell having the deformation detection sensor of the present invention on the inside or outside surface of its package case or by using a battery module housed in a package case having the deformation detection sensor of the present invention on the inside or outside surface of its package case or by using a package case for the battery pack having the deformation detection sensor of the present invention on the inside surface of its package case as a package case for the battery module.

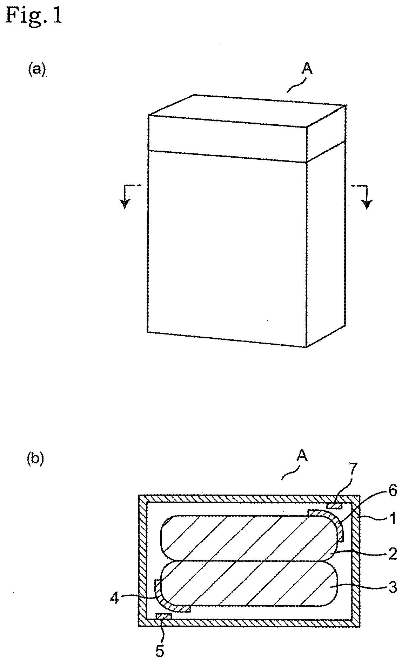

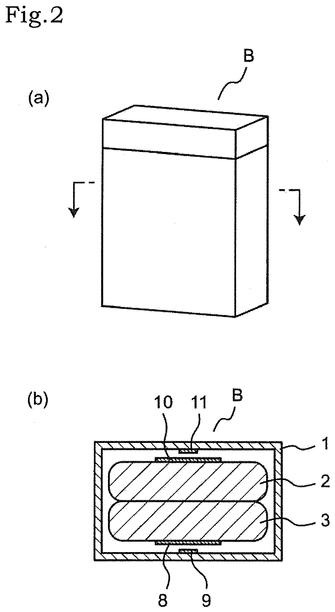

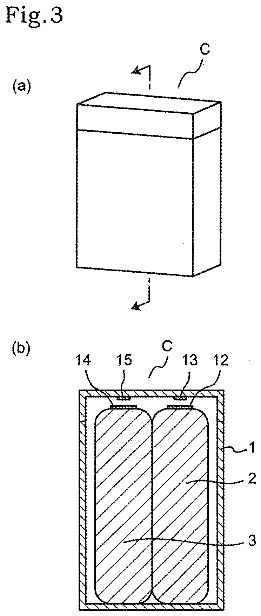

Figure 1 is a schematic view showing an example of a structure of the battery module, and Fig. 1 (a) is a perspective view of the battery module using the rectangular can-shaped package case, and Fig. 1 (b) is a transverse cross-sectional view of the battery module. The battery module A comprises two unit cells 2, 3 which are housed in a package case 1. A magnetic resin layer 6 is stuck on the curved corner part of the package case of the unit cell 2, and a magnetic sensor 7 is arranged on the inside surface of the package case 1 so as to approximately face the magnetic resin layer 6. Further, a magnetic resin layer 4 is stuck on the curved corner part of the unit cell 3, and a magnetic sensor 5 is arranged on the inside surface of the package case 1 so as to approximately face the magnetic resin layer 4. The bulging of the unit cell 2, 3 is detected by the magnetic sensor 5 and magnetic sensor 7, respectively. When the bulging which is not lower than a preset value is detected by the magnetic sensors 5, 7, a protection circuit (not shown) which is electrically connected with the magnetic sensors 5, 7 cuts off the current between an external device and the unit cells 2, 3. The magnetic resin layers 4, 6 can be stuck to the curved corner portion of the unit cells 2, 3 without peeling. In Fig. 1, although there is shown an example in which one magnetic sensor is arranged in each unit cell, a plurality of magnetic sensors may be arranged in the unit cell according to the shape and size of the battery body. Further, in Fig. 1, although there is shown an example in which the magnetic sensor is arranged on the inside surface of the package case, it can be obtained the same effect when the magnetic sensor is arranged on the outside surface of the package case. Further, Fig. 2 shows an example (B) of the battery module, in which the magnetic resin layers 8, 10 are stuck to the outside surface of the package case of the unit cells 2, 3 and the magnetic sensors 9, 11 are arranged on the inside surface of the package case 1. Further, Fig. 3 shows an example (C) of the battery module, in which the magnetic resin layers 12, 14 are stuck to the upper surface of the unit cells 2, 3 and the magnetic sensors 13, 15 are arranged on the upper inside surface of the package case 1.
In Figs. 1-3, although there is shown an example in which two unit cells are used, even when more than two unit cells are used, as in the case of Figs. 1-3, the magnetic resin layers can be stuck and the magnetic sensors can be arranged. Further, in Figs.1-3, although there is shown an example in which the magnetic resin layers are stuck to the unit cell, the magnetic resin layers may be stuck to the inside or outside surface of the package case of the battery module, and in that case, the magnetic sensors may be arranged on the inside or outside surface of the package case of the battery module.

The unit cells such as a known laminate type unit cell in which a laminate type battery body comprising a positive electrode and a negative electrode laminated via a separator is sealed with a laminate sheet, and the unit cells such as a known can type unit cell in which a winding type battery body comprising a positive electrode and a negative electrode wound via a separator is sealed in a metal can, may be used in the present invention.

In order to produce the battery module of the present invention, a method can be used, and the method comprises housing a plurality of unit cells in a battery module case, injecting a precursor for thermosetting resin including filler such as a magnetic filler into at least a portion of gap between the plurality of unit cells and the package case, and curing the precursor for thermosetting resin to form the resin layer. In this case, the magnetic resin layers may be formed on the inside surface of the package case or on the outside surface of the unit cell.

The precursor for thermosetting resin including magnetic filler is a mixed solution of resin before curing, for example, in the case of polyurethane elastomer, the precursor can be prepared by mixing an active hydrogen-containing compound, the magnetic filler and a catalyst, and further adding an isocyanate component followed by mixing and degassing. Also, the precursor can be prepared by mixing the magnetic filler with the isocyanate component, and adding a mixture of the active hydrogen-containing compound and the catalyst followed by mixing and degassing.

Further, the precursor for thermosetting resin including magnetic filler is injected into at least a portion of gap between the unit cell and the package case. The place on which the magnetic resin layer is formed is not particularly limited as long as the place is a gap between the unit cell and the package case.

Further, it is preferable to cure the precursor for thermosetting resin at the temperature range of 50-130 °C, preferably 55-120 °C , more preferably 60-110 °C for 1-24 hours.

Further, the method may comprises, before housing the unit cells in the battery module case, providing a case for forming a magnetic resin layer, housing the unit cells in the case for forming a magnetic resin layer, forming the magnetic resin layer outside of the unit cells, and housing the unit cells having magnetic resin layers in the battery module case. Further, when housing the unit cells having magnetic resin layers in the battery module case, the magnetic resin layer forming case may be removed from the unit cells or may be housed in the battery module as it is with the unit cells.

Further, as another production method, a method comprising sticking the produced magnetic resin on the predetermined portion of the unit cells or battery module may be used. In this case, it is preferable to heat the magnetic resin at the temperature range of 60-130 °C, preferably 70-1 20 °C, more preferably 80-110 °C for 10-60 minutes, after sticking the magnetic resin on the unit cells or battery module. The adhesive strength of the magnetic resin against the unit cells or battery module can be improved.

Further, a battery pack can be produced by electrically connecting a plurality of produced battery modules and housing those in a battery pack case.

### Examples

The present invention is further described below while referring to Examples, but it must be noted that the present invention is not limited by these examples alone.

The following ingredients were employed for the preparation of the magnetic resin (resin component: polyurethane elastomer).
TDI-100: toluene diisocyanate (2,4-body=100%) (manufactured by Mitsui Chemicals, Inc.)
Polyol A: a polyoxypropylene glycol obtained by adding propylene oxide to glycerin initiator, OHV56, functional group number of 3 (manufactured by Asahi Glass Co., Ltd.) Polyol B: a polyoxypropylene glycol obtained by adding propylene oxide to pentaerythritol initiator, OHV75, functional group number of 4 (manufactured by Toyo Tire & Rubber Co., Ltd.)
Polyol C: a polyester polyol as starting ingredients of 3-methyl-1,5-pentanediol and trimethylolpropane and adipic acid, OHV56, functional group number of 3 (manufactured by Kuraray Co., Ltd.).
Polyol D: a polyoxypropylene glycol obtained by adding propylene oxide to glycerin initiator, OHV168, functional group number of 3 (manufactured by Asahi Glass Co., Ltd.) Neodymium-based filler: MF-15P (average particle diameter of 133µm) (manufactured by Aichi Steel Co., Ltd.) Samarium-based filler: SmFeN alloy powder (average particle diameter of 2.6µm) (manufactured by Sumitomo Metal Mining Co., Ltd.)
Silver filler: Ag-HWQ 2.5µm (average particle diameter of 2.5µm) (manufactured by Fukuda Metal Foil & Powder Co., Ltd.)

Further, as a prepolymer, two kinds of prepolymer (A, B) shown in Table 1 were used. Prepolymer A contains 14.8 parts by weight of TDI-100 (NCO%=48.3%) and 85.2 parts by weight of polyol A (OHV= 56), and NCO% of the prepolymer A is 3.58%. Prepolymer B contains 18.8 parts by weight of TDI-100 (NCO%=48.3%) and 85.2 parts by weight of polyol B (OHV= 75), and NCO% of the prepolymer B is 4.55%.

**[Table 1]**

| | | Prepolymer A | Prepolymer B |
|---|---|---|---|
| TDI-100 | NCO%=48.3% | 14-8 (parts by weight) | 18.8 (parts by weight) |
| Polyol A | OHV= 56 | 85.2 (parts by weight) | - |
| Polyol B | OHV= 75 | - | 81.2 (parts by weight) |
| NCO % | | 3.58 (%) | 4.55 (%) |

### Example 1

In the reaction vessel, 85.2 parts by weight of polypropylene glycol as polyether polyol (manufactured by Asahi Glass Company, EXCENOL 3030, number average molecular weight 3000, functional group number of 3) was put and dehydrated under reduced pressure for 1 hour while stirring. After that, the reaction vessel was purged with nitrogen gas. To the reaction vessel, 14.8 parts by weight of 2,4-toluene diisocyanate (manufactured by Mitsui Chemicals, Inc., Cosmonate T-100) was added, and then was reacted for 3 hours while the temperature in the reaction vessel was maintained at 80 °C to synthesize an isocyanate-terminated prepolymer A.

Next, to a mixed solution containing 213.0 parts by weight of polypropylene glycol (manufactured by Asahi Glass Company, EXCENOL 3030, number average molecular weight 3000, functional group number of 3) and 0.39 parts by weight of lead octylate (Toei Kako Co., BTT-24), 631.16 parts by weight of neodymium-based filler (Aichi Steel Corp., MF-15P) was added to prepare a filler dispersion. This dispersion was defoamed under reduced pressure, and to this dispersion, 213.0 parts by weight of the above prepolymer A which was similarly defoamed under reduced pressure was added, and then subjected to mixing and defoaming by revolution-rotation mixer (Thinky Co., Ltd.). This dispersion was cast on the PET film having a 1.0 mm spacer and subjected to a release treatment, and a thickness of the cast dispersion was adjusted to 1 mm with a nip roll. Then, the cast dispersion was allowed to stand at room temperature for 30 minutes as the uneven distribution treatment, and thereby settling the magnetic filler. Then, the cast dispersion was cured at 80 °C for 1 hour to obtain an filler dispersed polyurethane elastomer. A magnetic resin was obtained by magnetizing the resulting elastomer with a magnetization device (manufactured by Denshijiki Industry Co., Ltd.). Formulation and manufacturing conditions are shown in Table 2.

The magnetic resins of Examples 2 to 8 and Comparative Examples 1-2 were prepared according to the formulation and the manufacturing conditions shown in Table 2.

### (Modulus of elasticity measurement)

According to JIS K-7312, a compression test was conducted by using an autograph AG-X (manufactured by Shimadzu Corporation) at room temperature and at the compression rate of 1 mm/min. A right circular cylinder shaped test piece having a thickness of 12.5 mm and a dimeter of 29.0 mm was used. The compression modulus of the test piece was calculated from the stress value at the compression time from 2.4% to 2.6%.

The produced magnetic resin was subjected to uneven distribution degree evaluation and deformation degree evaluation.

### (Uneven distributed evaluation)

A sample was cut from the prepared magnetic resin with a razor blade, a cross-section of the sample was observed using a digital microscope at a magnification of 100. Using an image analysis software("WinROOF" from Mitani Corporation), the obtained image was divided into three equal parts in the thickness direction, that is, an upper layer, middle layer and lower layer, and the number of particles of magnetic filler in each layer was counted. An abundance ratio of the magnetic filler in each layer was determined by calculating a ratio of the number of particles of each layer to that of the middle layer. Further, the uneven distribution degree was determined by calculating a value of [(the abundance ratio of the magnetic filler in the upper layer)-(the abundance ratio of the magnetic filler in the lower layer). The results are shown in Table 2.

### (Deformation degree evaluation)

A sample having a width of 15 mm was cut from the prepared magnetic resin and was wound around 1.44 Ah unit cell (size: length 90 mm × width 30 mm × thickness 4 mm) so that the high concentration portion of the magnetic filler is on the side of the unit cell. The shape followability of the magnetic resin to the unit cell was visually judged and employed as an index of deformation degree evaluation. The results are shown in Table 2.
○: Good adhesion is obtained on both of flat portion and corner portion (no bubble biting).
× : There is some poor adhesion on flat portion or corner portion (floating exists).

### (Sensor characteristic evaluation)

A sample having a size of 5 mm × 30 mm was cut from the prepared magnetic resin and was stuck on 1.44 Ah unit cell (size: length 90 mm × width 30 mm × thickness 4 mm) so that the high concentration portion of the magnetic filler is on the side of the unit cell. This unit cell was subjected to overcharging from a full charged state (4.3V) at 2.88Ah (2C). A time required for a magnetic flux to reach a predetermined value (1 gauss/sec) was measured, and the time (min) was used as an indicator of the sensor characteristics. As the magnetic sensor, a Hall element (Asahi Kasei Electronics Co., Ltd. EQ-430L) was used. Here, the shorter the time for the magnetic flux to reach the predetermined value, it indicates the higher sensor sensitivity. The results are shown in Table 2.

### Example 9

An isocyanate-terminated prepolymer A was synthesized in a similar manner as in Example 1. Next, to a mixed solution containing 213.0 parts by weight of polypropylene glycol (manufactured by Asahi Glass Company, EXCENOL 3030, number average molecular weight 3000, functional group number of 3) and 0.39 parts by weight of lead octylate (Toei Kako Co., BTT-24), 946.74 parts by weight of silver filler Ag-HWQ (manufactured by Fukuda metal foil & power Co., Ltd.) was added to prepare a filler dispersion. This dispersion was defoamed under reduced pressure, and to this dispersion, 100.0 parts by weight of the above prepolymer A which was similarly defoamed under reduced pressure was added, and then subjected to mixing and defoaming by revolution-rotation mixer (Thinky Co., Ltd.). This dispersion was cast on the PET film having a 1.0 mm spacer and subjected to a release treatment, and a thickness of the cast dispersion was adjusted to 1 mm with a nip roll.

A sample having a size of 5 mm by 30 mm was cut from the prepared electrically conductive filler containing resin (hereinafter, referred to as electrically conductive resin) and was subjected to gold vapor deposition on its upper and lower surfaces using an ion sputtering apparatus to prepare an electrode layer. A leading wire was connected with the electrode layer and the leading wire was connected with a digital multimeter (Agilent 34410A, manufactured by Agilent Technologies, Inc.). This electrically conductive resin was stuck to the unit cell in a similar manner as in Example 1, and the unit cell was subjected to overcharging test. A time required for a resistance change ratio of the electrically conductive resin to reach 10 was measured, and the time (min) was used as an indicator of the sensor characteristics. The results are shown in Table 2. Note that the resistance change ratio is defined to be a ratio of the resistance value of the electrically conductive resin before overcharging test and that of the electrically conductive resin after predetermined time passes.

### Example 10

Although Examples 1-9 show an example of deformation detecting sensor having a resin layer of a single layer structure, Example 10 shows another example of deformation detecting sensor having a resin layer of a multilayer structure. Specifically, the magnetic resin was produced and the sensor characteristic was evaluated by the following method.

### (Method for producing a magnetic resin)

A filler dispersed polyurethane elastomer was produced in a similar manner as in Example 1 except that the filler dispersion was prepared by adding 1275.2 parts by weight of neodymium-based magnetic filler and 317.64 parts by weight of toluene, and that the thickness of the spacer is 0.6mm.

Next, 213.0 parts by weight of polypropylene glycol (manufactured by Asahi Glass Company, EXCENOL 3030, number average molecular weight 3000, functional group number of 3) and 0.39 parts by weight of lead octylate (Toei Kako Co., BTT-24) was mixed to prepare a mixed solution. This mixed solution was defoamed under reduced pressure, and to this solution, 100.0 parts by weight of the above prepolymer A which was similarly defoamed under reduced pressure was added, and then subjected to mixing and defoaming by revolution-rotation mixer (Thinky Co., Ltd.). This reaction solution was cast on the filler dispersed polyurethane elastomer having a 0.4 mm spacer, and a thickness of the cast solution was adjusted to 0.4 mm with a nip roll. Then, the cast solution was cured at 80 °C for 1 hour to obtain a laminate consisting of a filler dispersed polyurethane elastomer and a polyurethane elastomer free from filler. A magnetic resin was obtained by magnetizing the resulting elastomer in a similar manner as in Example 1.

As for the obtained laminate, the following results were obtained: the uneven distribution degree was 68.4; the compression modulus was 2.17 MPa; the deformation degree was evaluated as "○"; and the sensor sensitivity was 37.9 (min).

**[Table2]**

| | | | Example 1 | Example 2 | Example 3 | Example 4 | Example 5 | Example 6 | Example 7 | Example 8 | Example 9 | Comparative Example 1 | Comparative Example 2 |
|---|---|---|---|---|---|---|---|---|---|---|---|---|---|
| | Prepolymer | Prepolymer A | 100 | 100 | 144 | 100 | | | 100 | | 100 | | |
| | | PrepolymerB | | | | | 100 | 140 | | 100 | | 100 | 100 |
| | Curing agent | Polyol A | 213 | 213 | 213 | 213 | | | | 213 | 213 | | |
| | | Polyol B | | | | | 406.3 | | | | | 541.5 | |
| | | Polyol C | | | | | | | 213 | | | | |
| | | Polyol D | | | | | | 36.1 | | | | | 30.1 |
| Formulation | Filler | Neodynium-based | 631.16 | | 631.16 | 631.16 | 1181.36 | 317.57 | 631.16 | 631.16 | 631.16 | 1496.8 | 303.57 |
| | | Samarium-based | | 631.16 | | | | | | | | | |
| | | Siver-based | | | | | | | | | 946.74 | | |
| | Solvent | Toluene | | | | | | 87 | | 200 | | | 83.1 |
| | Catalyst | Lead octylate | 0.39 | 0.39 | 0.39 | 0.39 | 0.63 | 0.17 | 3.91 | 0.39 | 0.39 | 8.02 | 0.16 |
| | NCO index | | 0.4 | 0.4 | 0.4 | 0.4 | 0.2 | 1 | 0.4 | 0.4 | 0.4 | 0.15 | 1.2 |
| Manufacturing conditions | Time of uneven distribution treatment(min) | | 30 | 30 | 3 | 60 | 30 | 30 | 0 | 0 | 0 | 30 | 30 |
| Result | Uneven distribution degree | | 60.7 | 57.6 | 4.7 | 83.1 | 54.8 | 48.7 | 0.7 | 92.4 | 4.2 | 63.7 | 21.3 |
| | compression modulus(MPa) | | 0.78 | 1.84 | 2.34 | 0.54 | 0.07 | 9.13 | 4.37 | 0.32 | 4.86 | 0.008 | 11.42 |
| | Deformation degree | | ○ | ○ | ○ | ○ | ○ | ○ | ○ | ○ | ○ | × | × |
| | Sensor sensitivity(min) | | 35.8 | 36.3 | 37.4 | 35.4 | 34.8 | 38.1 | 39.3 | 38.8 | 39.8 | 42.6 | 43.6 |

### (Results)

When the compression modulus is smaller than 0.01 MPa as in Comparative Example 1, the filler dispersed resin is difficult to handle because of its softness and high tackiness, and there is some floating on flat portion and corner portion. When the compression modulus is larger than 10 MPa as in Comparative Example 2, the filler dispersed resin is difficult to be wound around the battery body because of its hardness. On the other hand, in Examples 1-9, good adhesion on flat portion and corner portion of the unit cell was obtained. Further, Examples 1-10 showed good sensor characteristics as compared with Comparative Examples 1,2.

### Industrial Applicability

According to the present invention, it can be possible to further improve the safety of the nonaqueous electrolyte secondary battery without lowering the degree of freedom in designing the structure of the sealed secondary battery.

### Description of reference numerals

- 1: package case
- 2, 3: unit cell
- 4, 6, 8, 10, 12, 14: resin layer
- 5, 7, 9, 11, 13, 15: magnetic sensor
- A, B, C: battery module

## Claims

1. A deformation detecting sensor for a sealed secondary battery used with a unit cell, battery module and battery pack of the sealed secondary battery, comprising: at least a resin layer whose property changes in association with deformation of a portion to be measured, the resin layer having an elastic modulus within the range of 0.01-10 MPa.

2. The deformation detecting sensor according to claim 1, wherein the resin layer comprises a magnetic filler or electrically conductive filler.

3. The deformation detecting sensor according to claim 2, wherein the magnetic filler is unevenly distributed in the thickness direction of the resin layer.

4. The deformation detecting sensor according to claim 3, wherein the concentration of the magnetic filler on the portion to be measured side is high.

5. The deformation detecting sensor according to any one of claims 1-4, wherein the resin layer comprises a polyurethane resin or silicone resin.

6. The deformation detecting sensor according to any one of claims 1-5, wherein the portion to be measured is the outside surface of the unit cell.

7. A deformation detecting sensor system for sealed secondary battery comprising:
a deformation detecting sensor according to any one of claims 1-6; and
a detection part for detecting a change of a magnetic field caused by a magnetic resin layer.

8. A unit cell for sealed secondary battery comprising a battery body housed in a package case, the battery body comprising a positive electrode, a negative electrode and a separator, wherein the unit cell comprises a deformation detecting sensor according to any one of claims 1-6 attached on the outside surface thereof.

9. A battery module comprising a plurality of unit cells for sealed secondary battery electrically connected one another, each unit cell comprising a battery body housed in a package case, the battery body comprising a positive electrode, a negative electrode and a separator, wherein the battery module comprises a deformation detecting sensor according to any one of claims 1-6 attached on the outside surface of at least one unit cell or on the inside or outside surface of the package case of the battery module.

10. A battery pack comprising a plurality of battery modules according to claim 9, those which are electrically connected one another.

11. A method for producing a battery module according to claim 9, comprising:
housing a plurality of unit cells in a package case;
injecting a precursor for a resin layer into at least a portion of gap between the plurality of unit cells and the package case; and
curing the precursor to form the resin layer,
wherein the property of the resin layer changes in association with deformation of a portion to be measured, and wherein the resin layer has an elastic modulus within the range of 0.01-10 MPa.

12. A method for detecting a bulging of a unit cell, the method comprising detecting a change of a magnetic field caused by the magnetic layer by using a unit cell according to claim 8.

13. A method for detecting a bulging of a battery module, the method comprising detecting a change of a magnetic field caused by a magnetic layer by using a battery module according to claim 9.

14. A method for detecting bulging of a battery pack, the method comprising detecting a change of a magnetic field caused by a magnetic layer by using a battery pack according to claim 10.
